# EUROPEAN PATENT APPLICATION

(11) **EP 4 818 785 A1**
(43) Date of publication of application: **07.10.2026**
(21) Application number: 25305493.6
(22) Date of filing: 03.04.2025
(51) Int. Cl.: G02B 21/00, G02B 21/36, H01J 37/22

(54) **ENABLING COMBINED MEASUREMENTS OF SAMPLE**

(71) Applicant: Université Marie et Louis Pasteur, 25000 Besançon (FR); CENTRE NATIONAL DE LA RECHERCHE SCIENTIFIQUE, 75016 Paris (FR)
(72) Inventor: CHIPAUX, Mayeul, 25000 Besançon (FR); SHIRZAD, Hoda, 10127 Torino (IT)
(74) Representative: Bandpay & Greuter

(57) **Abstract**

The disclosure notably relates to a device for enabling combined measurements of a sample 100 using a first measurement apparatus 210 and an optical microscope 220 simultaneously. The sample is located inside of a chamber 211 of the first measurement apparatus. The system comprises a collection quadric surface mirror 310 located inside the chamber of the first measurement apparatus. The system further comprises a relay module 400 positioned between the collection mirror and a compensating module located outside the chamber of the first measurement apparatus. The relay module is configured to relay the light beam reflected by the collection mirror to the compensating module. The system further comprises the compensating module. Such a device forms an improved solution for enabling the effective combined measurement using a first characterization technique and an optical microscope simultaneously.

## Description

### TECHNICAL FIELD

The invention relates to the field of microscopy, and more specifically to a device, system and method for enabling the combined measurement of a sample using a first characterization technique and an optical microscope simultaneously.

### BACKGROUND

Current solutions for combining an optical microscopy line with an Electron Microscope, such as a Scanning Electron Microscope (SEM), rely on straightforward approaches like placing a parabolic mirror (mirror with a paraboloid surface) inside the SEM vacuum chamber, between the sample and the electron lens. This setup allows light to be collected from the sample and directed outside the chamber, or vice versa. While this method has the advantage of being compatible with existing SEMs and is commercially available through companies such as Gatan, Delmic, Attolight, and Horiba, it presents significant limitations. Notably, it drastically limits its imaging capabilities, as only a single point in an image can be exploited at a time, and the alignment procedures are highly constraining.

To address these issues, alternative approaches have been explored, such as designing a dedicated optical microscope objective integrated within the entire SEM system. For example, a company has developed a solution where both optical and electron microscopy lines are fully integrated into a single instrument. However, such integration imposes compromises on both the electron and optical paths, leading to trade-offs to the performance of both, such as resolution, collection efficiency, field of view and overall instrument versatility. This approach therefore significantly increases technical complexity and costs.

The challenges become even greater when attempting to combine an optical microscopy line with other types of electron microscopes, such as Transmission Electron Microscopes (TEM) or Scanning Tunneling Microscopes (STM), or even with non-electron-based techniques (such as synchrotron measurements).

Within this context, there is a need for an improved device that enables the effective combined measurements using a first characterization technique and an optical microscope simultaneously while overcoming the limitations of existing solutions.

### SUMMARY

It is therefore provided a device for enabling a combined measurement of a sample using a first measurement apparatus and an optical microscope simultaneously. The sample is located inside a chamber of the first measurement apparatus. The system comprises a collection quadric surface mirror located inside the chamber of the first measurement apparatus. The collection mirror reflects a light beam emitted by the sample towards the outside of the chamber. The system further comprises a relay module positioned between the collection mirror and a compensating module located outside the chamber of the first measurement apparatus. The relay module is configured to relay the light beam reflected by the collection mirror to the compensating module. The system further comprises the compensating module. The compensating module comprises at least one compensating quadric surface mirror configured to reflect the light beam relayed by the relay module towards the optical microscope. The relay module is configured to form an image of the collection mirror at the location of the compensating module and to convert the light beam reflected by the collection mirror to its symmetric. The compensating module is positioned so as to compensate for geometric aberration induced by the collection mirror.

The light beam emitted from a light source may undergo the same path of the beam emitted by the sample but in an opposite direction, e.g. toward the sample.

The device may comprise one or more of the following:
- A reflecting surface of the collection mirror is a paraboloid of parent focal length p1. The compensating module comprises one or more compensating parabolic mirrors. The relay module is in the form of an afocal system;
- The compensating module comprises a first compensating parabolic mirror of parent focal length p2. The first compensating mirror is configured for reflecting the light beam relayed by the relay module towards the optical microscope;
- The relay module comprises two lenses arranged along an optical axis between the collection mirror and the first compensating mirror. The two lenses are positioned to create an inverted image of the collection mirror at the location of the first compensating mirror. The first compensating mirror is positioned as the inverted counterpart of the collection mirror;
- The two lenses, respectively of focal f1 and f2 such that the ratio f2/f1 is approximatively equal to p2/p1 are configured in an afocal configuration. The two lenses are separated by a distance approximatively equal to the sum of f1+f2 each lens being positioned at a distance equal to their focal length (f1 or f2) from the collection mirror and the first compensating mirror, respectively;
- The relay module comprises two parabolic mirrors, the two parabolic mirrors of the optical module are of parent focal lengths p3 and p4 such that a ratio p3/p4 is approximatively equal to p1/p2;
- The relay module comprises a first spherical mirror of radius r1 and a second spherical mirror of radius r2 such that the ratio r1/r2 is approximatively equal to p1/p2;
- The compensating module further comprises a second compensating quadric surface mirror positioned above the first compensating mirror and rotated by 90 degrees relative to the first compensating mirror. The second compensating mirror reflects the light beam directed by the first compensating mirror. The compensating module optionally comprises a final lens positioned to modify the light beam reflected by the two quadric surface mirrors before the light beam reaches the optical microscope;
- The collection mirror is a first ellipsoid surface mirror positioned such that the sample is positioned at its first foci. The compensating module comprises a second ellipsoid surface mirror;
- The relay module comprises a single lens positioned between the first ellipsoid surface mirror and the second ellipsoid surface mirror. The single lens is configured to make an image of the first ellipsoid surface mirror at the position of the second ellipsoid surface mirror;
- The relay module comprises a spherical mirror positioned between the first ellipsoid surface mirror and the second ellipsoid surface mirror. The spherical mirror is configured to image the first ellipsoid surface mirror at the position of the second ellipsoid surface mirror, and one or several plane mirrors to reroute the light beam away from the first measurement apparatus chamber;
- The device further comprises a light source configured to emit an illumination beam propagating through the compensating module, the relay module and the collection mirror before reaching the sample and a beam separation optics configured to separate the illumination beam from the light beam emitted by the sample; and/or
- The collection mirror comprises a hole arranged such that a beam associated with the first measurement apparatus passes through the collection mirror to reach the sample.

It is further provided a system comprising the said device. The system further comprises the first measurement apparatus. Alternatively or additionally, the system further comprises the optical microscope.

It is further provided a method of use of the said device.

### BRIEF DESCRIPTION OF THE DRAWINGS

Non-limiting examples will now be described in reference to the accompanying drawings, where:
- FIG. 1 illustrates an example of the device;
- FIG. 2 shows a first example of the device with a parabolic collection mirror, a parabolic compensating mirror and an afocal relay module comprising two lenses;
- FIG. 3 shows a second example with a relay module comprising two parabolic mirrors;
- FIG. 4 shows a third example with a relay module comprising two spherical mirrors and plan mirrors;
- FIG. 5 illustrates an example with ellipsoidal collection and compensating mirrors;
- FIG. 6 shows relay module variants for the ellipsoidal configuration using a lens;
- FIG. 7 shows a relay module variant with a spherical mirror and a plane mirror;
- FIG. 8 illustrates an example with a compensating module comprising two parabolic mirrors and an additional lens; and
- FIG. 9 illustrates a complete system.

### DETAILED DESCRIPTION

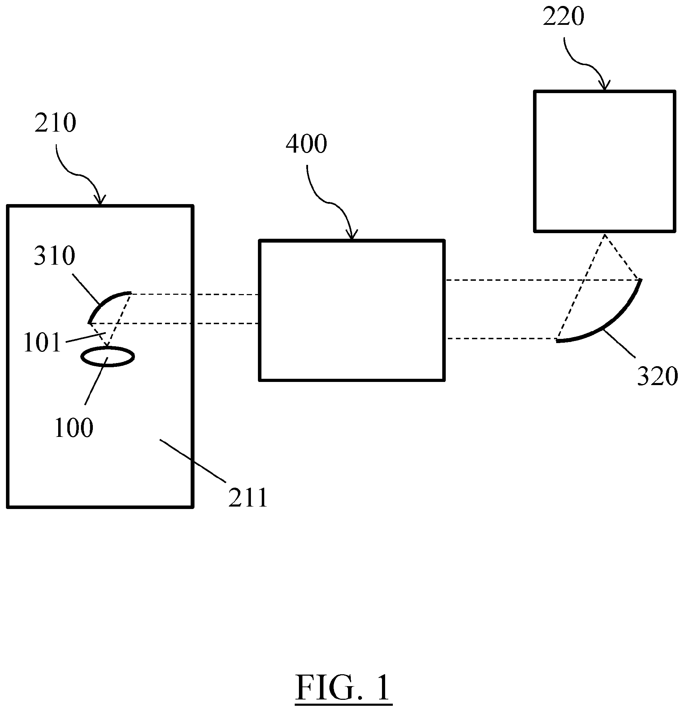

With reference to the illustration of FIG. 1, it is proposed a device for enabling a combined measurement of a sample 100 using a first measurement apparatus 210 and an optical microscope 220 simultaneously. The sample is located inside a chamber 211 of the first measurement apparatus. The system comprises a collection quadric surface mirror 310 located inside the chamber of the first measurement apparatus. The collection mirror reflects a light beam 101 emitted by the sample towards the outside of the chamber. The system further comprises a relay module 400 positioned between the collection mirror and a compensating module located outside the chamber of the first measurement apparatus. The relay module is configured to relay the light beam reflected by the collection mirror to the compensating module. The system further comprises the compensating module. The compensating module comprises at least one compensating quadric surface mirror 320 configured to reflect the light beam relayed by the relay module towards the optical microscope. The relay module is configured to form an image of the collection mirror at the location of the compensating module and to convert the light beam reflected by the collection mirror to its symmetric. The compensating module is positioned so as to compensate for geometric aberration induced by the collection mirror.

Such a device forms an improved solution for enabling the effective combined measurement using a first characterization technique and an optical microscope simultaneously.

Notably, the proposed device enables the combined measurement of a sample using two characterization techniques simultaneously while overcoming key limitations of existing solutions. It functions as a simple add-on, enhancing optical imaging capabilities without requiring major modifications to existing microscopes.

Compared to existing solutions comprising a collection mirror but neither comprising the relay nor the compensating modules, it enables high performance imaging capabilities and a simplified alignment procedure.

Compared to fully integrated systems, which are costly and complex, this system can be easily installed on existing microscopes, reducing constraints on the optical and electron paths while maintaining high image quality. Its compact design and efficient beam routing minimize space requirements inside the chamber of the first measurement apparatus and significantly lower the costs. It also provides improved versatility, and broader compatibility with different microscopy techniques.

Additionally, beyond electron microscopy, it offers a practical and cost-effective solution for optical imaging applications in general.

The device enables the combined measurement of a sample using two characterization techniques, in particular an optical technique and a non-optical technique. The term "combined measurement" is to be understood as data acquisitions that are carried out simultaneously or quasi-simultaneously by both techniques, the sample being analyzed concurrently by two different types of instruments. This configuration enables the correlation of information obtained from complementary modalities, such as optical microscopy and electron or scanning probe microscopy.

The first characterization technique may be implemented using a measurement apparatus such as a Scanning Electron Microscope (SEM), a Transmission Electron Microscope (TEM), a Scanning Tunneling Microscope (STM), or a system based on synchrotron radiation. The second technique, which is optical, is carried out using an optical microscope, which may be a standard widefield microscope, a confocal microscope, a fluorescence microscope, or any other system capable of receiving light performing measurements on it.

In examples, the invention may be used in contexts where the first measurement apparatus is also capable of performing fabrication operations on the sample, in addition to its measurement function. For example, the first measurement apparatus may be a focused ion beam (FIB) or a scanning electron microscope (SEM), which are commonly used in cleanroom environments for both imaging and nanofabrication purposes. In such cases, the optical microscope may be used to identify or localize a specific emitter within the sample, while the first measurement apparatus provides high-resolution imaging of the same area. Based on the combined observation, a fabrication step may then be performed in situ by the first measurement apparatus, such as structuring a nanophotonic element (e.g., an optical antenna) around the identified emitter. The combined use of the optical microscope and the first measurement apparatus for localizing and monitoring the emitter ensures that the system still performs a combined measurement within the meaning of the present disclosure, even if the first measurement apparatus is further used to carry out a fabrication operation.

The sample 100 is located inside a chamber of the first measurement apparatus 210. The expression "located inside" is understood to mean that the sample is placed within the measurement environment of the first apparatus, typically in a vacuum or controlled atmosphere enclosure (in which the free space is particularly limited), so as to be observable by the corresponding measurement probes (e.g., electron beam, X-rays, or scanning tips). The sample may be any object or material intended to be characterized by the combined use of the first measurement apparatus and the optical microscope. It may be fixed or mounted on a support, and may emit, reflect, or scatter light in response to excitation.

In order to enable optical access to the sample 100 from outside the chamber 211, the device comprises a dedicated optical path, formed by a succession of optical components arranged along an optical axis extending from the sample to the optical microscope. The device is designed to collect the light 101 scattered, emitted, or generated by the sample 100 in response to excitation by the first apparatus 210, an optical illumination through the optical microscope 220, a combination of both or any other source of luminescence, and to direct it toward the optical microscope 220 while preserving image quality.

The device comprises, as a first element in this path, a collection quadric surface mirror 310 located inside the chamber 211 of the first measurement apparatus. The collection mirror is optically coupled to the sample and is configured to receive the light beam 101 emitted by the sample, either by luminescence, scattering, or other light-emitting phenomena. The expression "reflecting a light beam emitted by the sample towards the outside of the chamber" means that the collection mirror is arranged to intercept the light emitted by the sample and redirect it along an optical path extending outside the measurement chamber, through an optical window or appropriate port of the chamber 211.

The collection mirror 310 comprises a reflective surface defined by a quadric geometry, such as an ellipsoid, paraboloid, or hyperboloid. These shapes are selected for their perfect sigmatism at one focus point and their ability to efficiently collect and direct light rays from a point-like source. The specific geometry may be selected based on the relative positions of the sample, the mirror, and the output aperture of the chamber.

Outside the chamber, the device comprises the compensating module, itself comprising the at least one compensating quadric surface mirror 320. This mirror is arranged to receive the light reflected by the collection mirror and to redirect it toward the optical microscope 220. In particular, parabolic mirrors produce a sharp image only at their focal point. Points located nearby slightly away from the focus point, geometric aberrations such as astigmatism, field curvature, or coma arise from the curved geometry of the collection mirror and the asymmetry of the optical path. Images resulting from those points are therefore affected by magnification variations and blur. The compensating module is designed to correct the geometric aberrations introduced by the collection mirror 310. The compensating mirror is shaped and positioned to cancel out these aberrations, allowing the formation of a corrected image suitable for optical microscopy.

Between the collection mirror 310 and the compensating module, the device comprises a relay module 400, positioned along the optical axis connecting the collection mirror 310 to the at least one compensating mirror 320 of the compensating module, and configured to ensure proper transmission and optical conjugation between these elements. The relay module is configured to relay the light beam reflected by the collection mirror to the compensating module while maintaining the spatial and angular properties of the beam.

In particular, the relay module 400 is configured to form an optical image of the collection mirror 310 at the location of the compensating mirror 320. The relay module is also configured to produce a symmetric light beam, in the sense that the relay module reproduces the geometry of the original beam, eventually inverted magnified or reduced, onto the compensating module. This configuration allows the compensating module to receive a faithful reproduction of the aberrated beam, such that it can effectively perform the compensating transformation and restore the optical quality of the signal.

The compensating module is positioned so as to compensate for geometric aberration induced by the collection mirror 310. In practical terms, this means that the compensating mirror is placed at the conjugate position of the collection mirror 310, and has a surface geometry chosen to counterbalance the geometrical aberrations introduced in the first part of the path.

The device may further comprise additional optical elements such as plane mirrors, arranged to fold the optical path in a compact configuration.

To ensure the correct alignment and relative positioning of the optical components, the device may comprise a support structure or housing (not illustrated). This housing may hold the elements of the relay module and the compensating module in fixed positions relative to each other, along a defined optical axis. The collection mirror 310, which is located inside the chamber of the first measurement apparatus, may be mounted directly on internal surfaces of the chamber, or may be fixed using dedicated internal mechanical supports. Although it is not mechanically supported by the external housing, the support structure may comprise mounting means configured to attach to the chamber, so as to maintain a defined and stable positioning between the internal collection mirror and the remaining optical components of the device. The support structure may further comprise adjustable mounts or kinematic stages to allow for initial calibration and fine tuning, and may be configured to attach to the base of the optical microscope, ensuring overall mechanical stability and alignment of the system.

The support structure may further comprise a mechanism that allows to retract the collection mirror away from the sample and enable measurement operations with the first measurement apparatus exclusively.

The compact design and modularity of the device allow it to be implemented as an add-on to existing microscopy equipment. It enables users to perform combined measurements without requiring major modifications to the instruments involved, thus reducing complexity and cost.

In the context of the present invention, the term device refers to the assembly of optical components configured to collect, route, and correct the light beam emitted by the sample, including the collection mirror, relay module, and compensating module. The invention also encompasses a system comprising the device in combination with at least one of the measurement instruments used to perform the combined measurement. In particular, the system may comprise the first measurement apparatus (such as a SEM, TEM, STM, or synchrotron-based setup) and/or the optical microscope used for acquiring the image. The system is designed to enable the simultaneous or quasi-simultaneous acquisition of complementary data from both measurement techniques, with the device ensuring optical coupling between the sample located within the first apparatus and the optical microscope.

The invention also relates to a method of using the said device. The method may comprise: placing a sample inside the chamber of the first measurement apparatus; collecting the light beam emitted by the sample using the collection quadric surface mirror located inside the chamber; relaying the collected light beam to the outside of the chamber using the relay module; reflecting the relayed light beam toward the optical microscope using the compensating module comprising the at least one compensating quadric surface mirror; and acquiring an optical image of the sample using the optical microscope. The method may further comprise simultaneously analyzing the sample using the first measurement apparatus, so as to perform a combined measurement using both techniques.

The optical microscope 220 may be configured in a single pixel configuration and may comprise a single pixel detector configured to detect the optical intensity issued from the sample through the collection mirror, the relay module, the compensating module, and optical microscope components.

In this configuration, the confocal microscope may be further configured in confocal configuration and may further comprise a pinhole conjugated with the sample through the compensation module, the relay module, the collection mirror, and additional lenses and mirrors. The single pixel photodetector may be positioned after the pinhole in order to collect the light corresponding to a single optical section of the sample.

The optical microscope 220 may further comprise a beam steering module, such as a steering mirror, as well as an afocal system, both being configured to dynamically steer the conjugated collection point on the sample and thereby allow the acquisition of a confocal image by point-by-point scanning.

In another embodiment, the optical microscope 220 may be configured in a widefield configuration, and may comprise an image acquisition device, such as a camera, and an additional objective lens dedicated to image the sample on the camera through the collection mirror, the relay module, the compensation module, the optical microscope objective, and the said additional objective lens.

In certain embodiments, the optical microscope 220 may combine both a confocal detection path and a widefield microscopy path, the two paths being separated by a removable plane mirror or a beam splitter. This configuration enables switching between high-resolution point-scanning and full-field imaging modes or operating both simultaneously.

The optical microscope 220 may also comprise a characterization module, such as a spectrometer, separated from the photodetector by a beam splitter or a removable plane mirror, allowing spectroscopic analysis of the optical signal emitted by the sample.

The compensating module is now described in more detail. In first examples, the reflecting surface of the collection mirror may be a paraboloid (i.e., a parabolic mirror) having a parent focal length p1. In such examples, the compensating module may comprise one or more compensating parabolic mirrors, and the relay module may be implemented as an afocal system.

The compensating module may comprise a first compensating parabolic mirror having a parent focal length p2. The first compensating mirror may be configured to reflect the light beam relayed by the relay module toward the optical microscope. In certain embodiments, the compensating module may comprise only the first compensating mirror. In that case, the numerical aperture of the first compensating mirror being approximately similar to that of the collection mirror (e.g., within about 40%). In other embodiments, the compensating module may further comprise a second compensating quadric surface mirror, which may be positioned after the first compensating mirror and rotated by 90 degrees relative to it. The second compensating mirror may be configured to reflect the light beam directed by the first compensating mirror. In examples, the compensating module may also comprise a final lens, which may be positioned to modify the light beam reflected by the two quadric surface mirrors before it reaches the optical microscope.

In second examples, the compensating module may comprise ellipsoidal mirrors. The collection mirror may be a first ellipsoid surface mirror positioned such that the sample is located at its first focus, the mirror thereby forming an image of the sample at its second focus. The compensating module may comprise a second ellipsoid surface mirror.

The relay module 400 is now described in more detail. The relay module may comprise any suitable combination of mirrors and/or lenses configured to relay the light beam reflected by the collection mirror to the compensating module. The relay module may be configured to form an image of the collection mirror-potentially magnified or reduced-at the location of the compensating mirror, and to convert the light beam into it's a symmetric configuration, thereby enabling geometric compensation.

In first examples, the relay module may comprise two lenses arranged along an optical axis between the collection mirror and the first compensating mirror. These lenses may be positioned to create an inverted image of the collection mirror at the location of the first compensating mirror, which may thus be positioned as its inverted counterpart. When the compensating module comprises a first compensating parabolic mirror of parent focal length p2, the lenses may have focal lengths f1 and f2 such that the ratio f2/f1 may be approximately equal to p2/p1 (e.g., within about 40%). The lenses may be separated by a distance approximately equal to f1 + f2 (e.g., within about 40%), and each lens may be positioned at a distance equal to its focal length from the collection mirror and the first compensating mirror, respectively.

In second examples, the relay module may comprise two parabolic mirrors of parent focal lengths p3 and p4, respectively, the ratio p3/p4 may be approximately equal to p1/p2 (e.g., within about 40%).

In third examples, the relay module may comprise a first spherical mirror of radius r1 and a second spherical mirror of radius r2, such that the ratio r1/r2 may be approximately equal to p1/p2 (e.g., within about 40%). The relay module may further comprise two additional mirrors (e.g., plane mirrors or 45-degree fold mirrors), and may be configured such that the light beam successively encounters the first spherical mirror, the two fold mirrors, and the second spherical mirror before reaching the compensating module.

When the compensating module comprises ellipsoidal mirrors (as in the second examples above), the relay module may comprise a single lens positioned between the first and second ellipsoid surface mirrors, the lens being configured to image the first ellipsoid mirror at the position of the second ellipsoid mirror. In a variant, the relay module may comprise a spherical mirror and one or several plane mirrors, the spherical mirror being configured to image the first ellipsoid mirror at the position of the second ellipsoid mirror, and the plane mirrors being used to reroute the light beam away from the first measurement apparatus chamber, for easier integration.

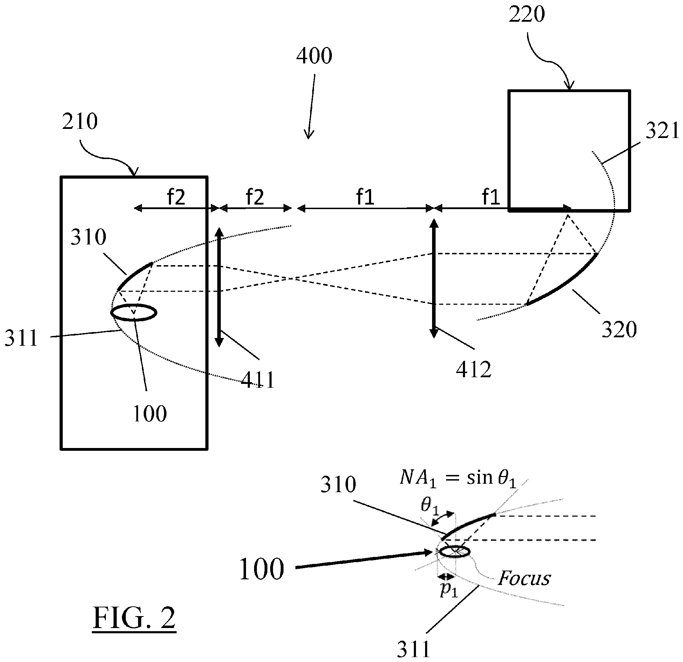

With reference to FIGs. 2 to 9, examples of implementation of the device are now presented.

FIG. 2 illustrates a first example of the device according to the present invention. In this example, the collection mirror 310 comprises a reflecting surface in the form of a paraboloid, i.e. a parabolic mirror having a parent focal length p1. The collection mirror 310 is located inside the chamber of the first measurement apparatus and is configured to collect a light beam emitted by the sample and reflect it toward the outside of the chamber. In this representation, the paraboloid 311 denotes the remaining portion of the paraboloidal geometry from which the surface of the collection mirror 310 is derived. In this embodiment, the relay module 400 is implemented as an afocal system, and the compensating module 320 comprises a single parabolic mirror having a parent focal length p2.

Parameter p1 may typically be on the order of a few millimeters, for example 4 mm, so that the corresponding mirror has dimensions suitable for fitting within the vacuum chamber of the first measurement apparatus. Parameter p2 may be equal to p1 or may differ from it

The compensating mirror 320 is arranged outside the chamber and is configured to receive the light beam relayed by the relay module and reflect it toward the optical microscope. The numerical aperture of the compensating mirror 320 is approximately equal to that of the collection mirror 310 (e.g., within about 40%) in order to ensure optimal geometric compensation. The mirror 320 is positioned and oriented to act as the inverted counterpart of the collection mirror 310, allowing aberrations introduced by the collection mirror to be effectively corrected. The resulting optical path enables high-quality imaging from outside the chamber, despite the curved geometry and space constraints inside.

The relay module 400 comprises two lenses 411 and 412, which are arranged on an afocal configuration. These lenses are positioned along an optical axis extending between the collection mirror 310 and the compensating mirror 320. These lenses are configured to form an inverted image of the collection mirror 310 at the location of the compensating mirror 320. By "inverted image," it is meant that the optical conjugation established by the lenses replicates the geometry of the collection mirror in a reversed manner. This allows the compensating mirror, position as inverted counterpart of the collection mirror to receive the beam under conditions similar to those under which the collection mirror emitted it, but with reversed aberrations, thereby enabling compensation.

The lenses 411 and 412 have focal lengths f1 and f2, respectively, such that the ratio f2/f1 is approximately equal to p2/p1 (e.g., within about 40%). As illustrated in FIG. 2, the two lenses are separated by a distance approximately equal to the sum f1 + f2 (e.g., within about 40%), forming a 4f-type afocal arrangement. Each lens is positioned such that its optical center is located at a distance approximately equal to its focal length from the adjacent parabolic mirror (e.g., within about 40%): lens 411 is at a distance f1 from the collection mirror 310, and lens 412 is at a distance f2 from the compensating mirror 320. This configuration ensures that the light beam remains collimated between the two lenses, that the desired magnification or demagnification is applied and that the compensating mirror efficiently compensate the geometrical aberration introduced by the collection mirror.

Focal lengths f1 and f2 may be equal to 30 cm or 40 cm so that the corresponding lenses can be positioned outside the chamber. Using shorter focal lengths is also conceivable to achieve a more compact system outside the chamber. In this case, one or both lenses may be placed inside the vacuum chamber, with the associated drawbacks

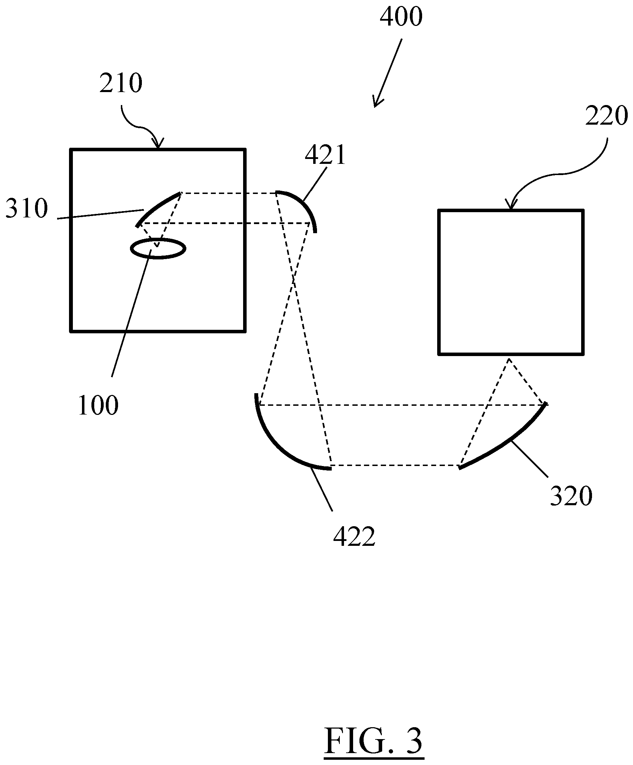

FIG. 3 illustrates a second example of the device according to the present invention. In this example, similarly to the configuration shown in FIG. 2, the collection mirror 310 is a parabolic mirror having a parent focal length p1, and the compensating module 320 comprises a single compensating parabolic mirror of parent focal length p2, the numerical aperture of which is approximately similar to that of the collection mirror.

In this configuration, the relay module 400 comprises two parabolic mirrors, referenced 421 and 422. The first parabolic mirror 421 may be positioned facing the collection mirror 310, along a first direction of propagation of the light beam. The mirror 421 is configured to receive the light beam reflected by the collection mirror 310, and to reflect it in a second direction oriented approximately orthogonally to the first one (i.e., rotated by about 90° in space). The second parabolic mirror 422 is positioned to receive the beam reflected by mirror 421 and to redirect it toward the compensating mirror 320, along a third direction, again rotated by approximately 90° with respect to the previous one.

The two parabolic mirrors 421 and 422 may have parent focal lengths p3 and p4, respectively, and effective focal lens f3 and f4 selected such that the ratio r3/r4 is approximately equal to p1/p2 (e.g., within about 40%), in the case of in the case 90° off axis parabolic mirrors, their effective focal lens being equal to twice their parent focal lens, f3 = 2*p3 and f4 = 2*p4. The two parabolic mirrors 421 and 422 are separated by a distance approximately equal to the sum of their effective focal lens f3 + f4 afocal arrangement. Each parabolic mirrors 421 and 422 is positioned at a distance approximately equal to its effective focal lens to the adjacent parabolic collection or compensating mirror (e.g., within about 40%).

This relay arrangement is fully reflective and allows the light beam to undergo a symmetric optical transformation, so that the compensating mirror 320 receives an inverted version of the beam initially reflected by the collection mirror 310, thereby enabling geometric aberration compensation. This configuration may be advantageous for maintaining achromaticity and avoiding dispersion effects. This is also particularly suitable for compact integration where folding the optical path is necessary.

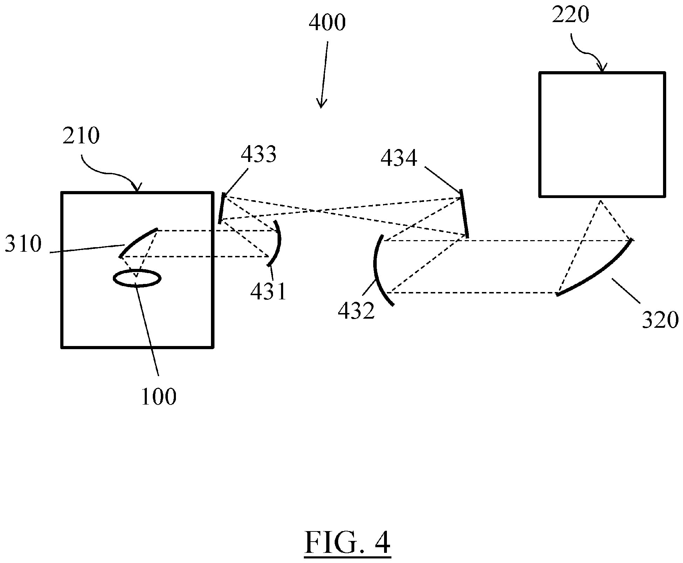

FIG. 4 illustrates a third example of the device according to the present invention. As in the examples of FIGs. 2 and 3, the collection mirror 310 is a parabolic mirror of parent focal length p1, and the compensating module 320 comprises a single parabolic mirror of parent focal length p2, the numerical aperture of which may be approximately equal to that of the collection mirror (e.g., within about 40%).

In this example, the relay module 400 comprises a first spherical mirror 431 of radius r1 and a second spherical mirror 432 of radius r2, each spherical mirror having an effective focal f1 and f2 length equal to the half of their radius r1 and r2. The two spherical mirrors are arranged to successively redirect the light beam from the collection mirror 310 to the compensating mirror 320. The ratio f1/f2 may be approximately equal to p1/p2 (e.g., within about 40%) so as to preserve the required optical symmetry and enable effective geometric compensation. The two spherical mirrors are separated by a distance approximately equal to the sum f1 + f2 (e.g., within about 40%), forming a 4f-type afocal arrangement. Each lens is positioned such that its optical center is located at a distance approximately equal to its focal length from the adjacent parabolic mirror (e.g., within about 40%).

The relay module may further comprise two plane mirrors 433 and 434, arranged to fold the optical path in a compact configuration. As illustrated, the light beam reflected by the collection mirror 310 may first encounter the first spherical mirror 431, which reflects it toward the first plane mirror 433. The beam is then successively reflected by the second plane mirror 434 and the second spherical mirror 432, before reaching the compensating mirror 320. This sequence of reflections forms a three-dimensional folded path, which allows integration of the device in constrained environments while maintaining alignment and aberration compensation.

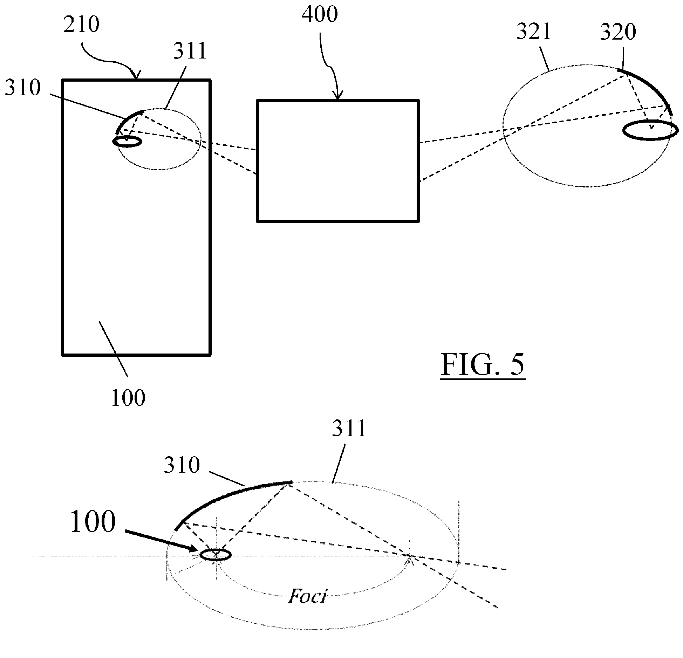

FIG. 5 illustrates a fourth example of the device according to the present invention. In this example, the collection mirror 310 is a first ellipsoid surface mirror, positioned such that the sample is located at its first focus. In this representation, the ellipsoid 311 denotes the remaining portion of the ellipsoidal geometry from which the surface of the collection mirror 310 is derived. In this configuration, the mirror is adapted to collect the light emitted by the sample and direct it toward its second focus, where an intermediate optical image of the sample is formed. The compensating module comprises a second ellipsoid surface mirror 320, arranged to receive the light from the collection mirror and redirect it toward the optical microscope. The second ellipsoid mirror is positioned such that it coincides with the image of the first ellipsoid mirror., thereby preserving the optical conjugation. The ellipsoid 321 denotes the remaining portion of the ellipsoidal geometry from which the surface of the second ellipsoid mirror is derived.

The relay module 400 in this example may comprise any suitable combination of lenses and/or mirrors configured to transmit the light beam from the second focus of the collection mirror to one of the foci of the compensating mirror, while maintaining image quality and alignment. The relay module serves to adapt the beam path to physical constraints and may also compensate for angular or spatial deviations.

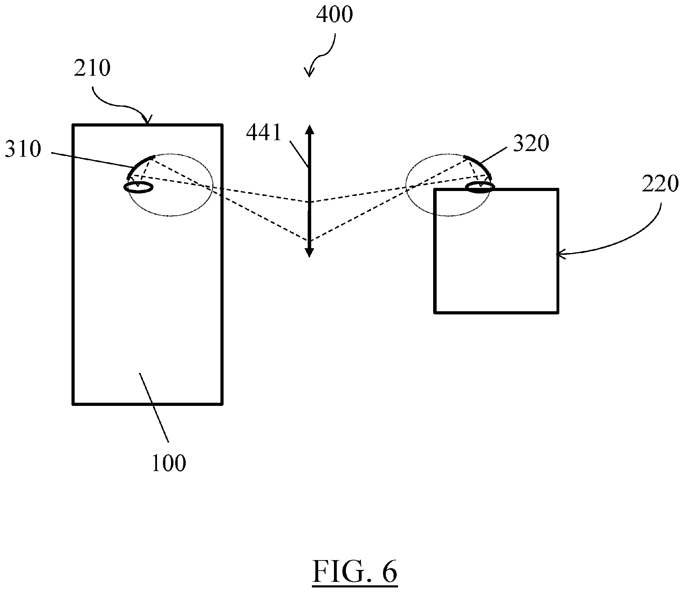

A specific example of such a configuration is illustrated in FIG. 6. In the example of FIG. 6, the relay module 400 comprises a single lens 441 of focal distance f positioned between the first and second ellipsoid surface mirrors. For example, the lens may be positioned at a distance approximately equal to 2*f from both the collection mirror and the compensating mirror so as to image the first ellipsoid mirror at the location of the second ellipsoid mirror, thus ensuring proper transmission of the image through the relay system with minimal complexity.

In another variant, the relay module may comprise a spherical mirror positioned between the first and second ellipsoid surface mirrors, the lens being configured to image the first ellipsoid mirror at the position of the second ellipsoid mirror. In this case, the relay module may further comprise one or several plane mirrors, configured to reroute the light beam away from the chamber of the first measurement apparatus, allowing for more compact integration and flexible positioning of the optical components outside the chamber.

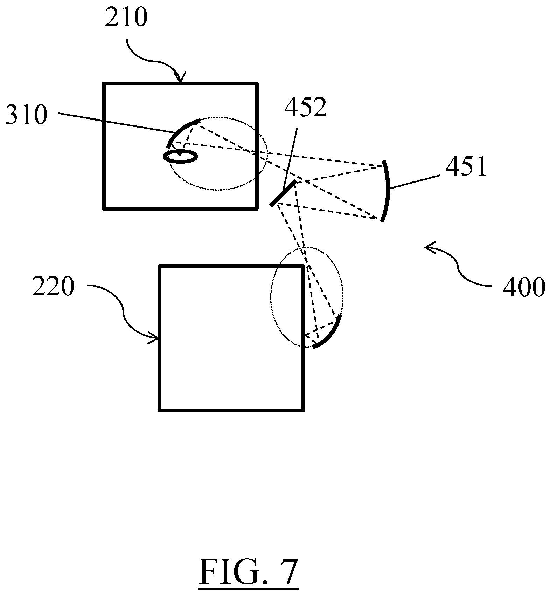

FIG. 7 illustrates a variant of the device based on the ellipsoidal mirror configuration described in FIG. 5, and more specifically, a variant of the relay module as compared to the example of FIG. 6. As in FIG. 6, the collection mirror 310 is a first ellipsoid surface mirror positioned such that the sample is located at its first focus, and the compensating module 320 comprises a second ellipsoid surface mirror.

In this variant, the relay module 400 comprises a spherical mirror 451 and a plane mirror 452. The spherical mirror 451 is positioned to receive the light beam coming from the second focus of the collection mirror 310. It reflects the beam toward the plane mirror 452, which in turn redirects it toward the second ellipsoid surface mirror 320, located in the compensating module. The orientation of the mirrors is such that the spherical mirror 451 introduces a focusing or imaging function, while the plane mirror 452 serves to fold the optical path, facilitating the integration of the relay module into a compact geometry.

This configuration offers an alternative to the lens-based relay system of FIG. 6, and allows for an all-reflective implementation, which may be advantageous for maintaining achromaticity and avoiding dispersion effects.

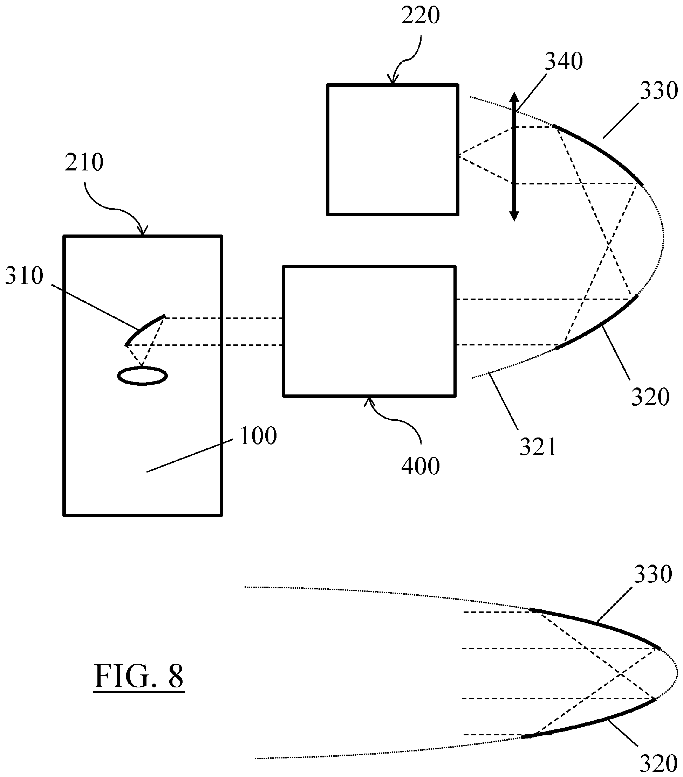

FIG. 8 illustrates a further example of the device, differing from the previous figures by the configuration of the compensating module. In this example, the collection mirror 310 and the relay module 400 may be configured as in any of the previous examples (e.g., as in FIG. 2 or FIG. 3), with the light beam reaching a modified compensating stage comprising two reflective elements.

More specifically, the compensating module comprises a first compensating parabolic mirror 320 having a parent focal length p2, and a second compensating quadric surface mirror 330. The second mirror 330 is positioned above the first mirror 320, and is rotated by 90 degrees relative to the first mirror. In operation, the first compensating mirror 320 receives the light beam from the relay module and reflects it upward toward the second mirror 330, which in turn reflects the beam laterally toward the optical microscope. In that configuration, the numerical aperture of the two compensating mirrors can be approximately equal to half the one of the collection mirror (e.g. within 40%).

As illustrated in FIG. 8, the two mirrors 320 and 330 may be segments of a common parabolic surface-that is, they may both lie on the same theoretical paraboloid. Accordingly, in certain embodiments, the two mirrors may be formed as separate segments of a single parabolic mirror, or may even constitute two contiguous regions of a continuous reflective surface, depending on mechanical and optical design considerations.

Optionally, the compensating module may further comprise a final lens 340 positioned downstream of the second mirror 330. This lens may be configured to adjust or condition the light beam before it enters the optical microscope-e.g., to adapt its divergence, correct residual aberrations, or refocus it onto a detection plane such as a camera or pinhole.

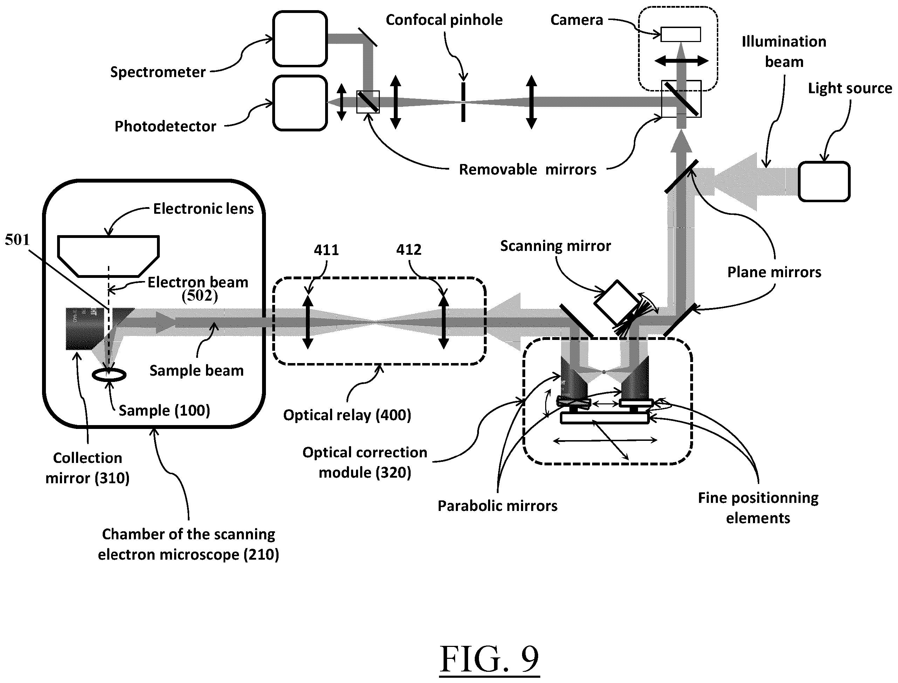

FIG. 9 illustrates a complete example of the device and system according to the present invention, showing both the internal optical path and the integration with components of the first measurement apparatus and the optical microscope. The figure notably illustrates the full light path from the sample to the optical detection system, as well as the beam injection path from a light source.

The collection mirror 310 is implemented as a parabolic mirror and comprises a central hole 501. This hole is arranged such that a beam 502-for example, an electron beam or an ion beam-associated with the first measurement apparatus may pass through the collection mirror 310 to reach the sample 100. This configuration enables simultaneous operation of the optical and non-optical measurement systems without obstruction, while preserving the collection efficiency of the mirror.

The relay module 400 comprises two lenses 411 and 412, arranged along the optical axis between the collection mirror 310 and the compensating module. These lenses are positioned to create an inverted image of the collection mirror at the location of the first compensating parabolic mirror 320, which is thus positioned as its inverted counterpart. This afocal configuration enables the symmetric correction of geometric aberrations introduced by the collection mirror. The compensating module comprises two parabolic mirrors (320 and 330), as previously described. It further includes fine positioning elements enabling the adjustment of their relative positions and orientations. These adjustments allow for fine-tuning of alignment and optimization of image quality.

Downstream of the compensating module, the system includes a scanning mirror, configured to steer the collected beam dynamically. The light beam then encounters one or more plane mirrors, which fold the optical path. The light source is also provided and is arranged such that its emitted beam is directed toward the second plane mirror, which reflects it back along the same optical path in reverse, toward the sample 100. This configuration enables illumination of the sample via the same optical train used for collection, supporting reflectance or fluorescence measurements.

The returning light beam from the sample is directed toward a confocal detection module, which comprises two lenses placed on either side of a confocal pinhole. This module is configured such that the pinhole is optically conjugated with the sample, through the compensating module, the relay module, the collection mirror, and the intermediate optical components. A single-pixel photodetector is positioned downstream of the pinhole to detect the optical signal with spatial resolution.

In addition, the system comprises a wide field path that comprises a camera and a camera objective lens to acquire an image directly. It is coupled to the optical path via a beam splitter or a removable plane mirror. This allows a portion of the collected light to be redirected to the camera for direct imaging while the remainder is sent to the photodetector. The system also comprises a characterization module, such as a spectrometer, which is coupled to the optical path via a beam splitter or a removable plane mirror. This configuration enables the simultaneous acquisition of spatial and spectral information, and enhances the versatility of the optical microscope integrated into the system.

The present device allows combining multiple advantages typically not available together in existing solutions. It can be implemented as a simple optical add-on, which can be installed on existing instruments without modifying their intrinsic functionalities. This modularity enables the device to be adapted to a variety of setups while maintaining compatibility with conventional systems.

Despite its simplicity, the invention enables optical performances comparable to high-end microscope objectives, particularly in terms of spatial resolution, collection efficiency, and field of view. In certain cases, the performance may even approach or exceed that of standard objectives with high numerical aperture, while relying exclusively on reflective optics.

The use of off-axis parabolic mirrors offers natural advantages in compactness and achromatic operation. These mirrors are well suited for environments where vertical space is limited, such as in scanning electron microscopes. Their geometry also allows for integration with additional beams, for example by including a central aperture to allow the passage of an electron or ion beam.

Compared to existing solutions based on refractive objectives or embedded reflective optics, the present invention offers a more compact, flexible, and cost-effective alternative. It can be integrated on a wide range of platforms, including but not limited to electron microscopes, and does not require substantial modification of existing hardware.

In addition, the invention addresses the intrinsic limitations of parabolic mirrors for imaging. While such mirrors offer excellent focusing properties at the focal point, they suffer from aberrations when imaging across a wider field. These aberrations are compensated in the present system through the use of a second mirror and a relay module configured to restore image quality. This arrangement enables robust, stable imaging without complex alignment procedures.

The overall result is a simple, compact, and adaptable system that offers advanced optical imaging capabilities in environments where conventional solutions are either impractical or prohibitively expensive. The invention supports a wide range of applications and can be implemented at a contained cost, while preserving high-quality optical performance.

## Claims

1. A device for enabling a combined measurement of a sample (100) using a first measurement apparatus (210) and an optical microscope (220) simultaneously, the sample (100) being located inside a chamber (211) of the first measurement apparatus, the system comprising:
• a collection quadric surface mirror (310) located inside the chamber of the first measurement apparatus, the collection mirror reflecting a light beam (101) emitted by the sample towards the outside of the chamber;
• a relay module (400) positioned between the collection mirror and a compensating module located outside the chamber of the first measurement apparatus, the relay module being configured to relay the light beam reflected by the collection mirror to the compensating module; and
• the compensating module comprising at least one compensating quadric surface mirror (320) configured to reflect the light beam relayed by the relay module towards the optical microscope,
wherein the relay module is configured to form an image of the collection mirror at the location of the compensating module and to convert the light beam reflected by the collection mirror to its symmetric, the compensating module being positioned so as to compensate for geometric aberration induced by the collection mirror.

2. The device of claim 1, wherein a reflecting surface of the collection mirror is a paraboloid of parent focal length p1, the compensating module comprising one or more compensating parabolic mirrors, the relay module being in the form of an afocal system.

3. The device of claim 2, wherein the compensating module comprises a first compensating parabolic mirror of parent focal length p2, the first compensating mirror being configured for reflecting the light beam relayed by the relay module towards the optical microscope.

4. The device of claim 2, wherein the relay module comprises two lenses arranged along an optical axis between the collection mirror and the first compensating mirror, the two lenses being positioned to create an inverted image of the collection mirror at the location of the first compensating mirror, the first compensating mirror being positioned as the inverted counterpart of the collection mirror.

5. The device of claim 4, wherein the two lenses respectively of focal f1 and f2 such that a ratio f2/f1 is approximatively equal to p2/p1 are configured in an afocal configuration, the two lenses being separated by a distance approximatively equal to the sum of f1+f2 each lens being positioned at a distance equal to their focal length (f1 or f2) from the collection mirror and the first compensating mirror, respectively.

6. The device of claim 3, wherein the relay module comprises two parabolic mirrors, the two parabolic mirrors of the optical module are of parent focal lengths p3 and p4 such that a ratio p3/p4 is approximatively equal to p1/p2.

7. The device of claim 3, wherein the relay module comprises a first spherical mirror of radius r1 and a second spherical mirror of radius r2 such that a ratio r1/r2 is approximatively equal to p1/p2.

8. The device of any one of claims 3 to 7, wherein the compensating module further comprises a second compensating quadric surface mirror positioned above the first compensating mirror and rotated by 90 degrees relative to the first compensating mirror, the second compensating mirror reflecting the light beam directed by the first compensating mirror, the compensating module optionally comprising a final lens positioned to modify the light beam reflected by the two quadric surface mirrors before the light beam reaches the optical microscope.

9. The device of claim 1, wherein the collection mirror is a first ellipsoid surface mirror positioned such that the sample is positioned at its first foci, the compensating module comprising a second ellipsoid surface mirror.

10. The device of claim 9, wherein the relay module comprises a single lens positioned between the first ellipsoid surface mirror and the second ellipsoid surface mirror, the single lens being configured to image the first ellipsoid surface mirror at the position of the second ellipsoid surface mirror.

11. The device of claim 9, wherein the relay module comprises a spherical mirror positioned between the first ellipsoid surface mirror and the second ellipsoid surface mirror, the spherical mirror being configured to image the first ellipsoid surface mirror at the location of the second ellipsoid mirror, and one or several plane mirrors to reroute the light beam away from the first measurement apparatus chamber.

12. The device of any one of claims 1 to 11, further comprising a light source configured to emit an illumination beam propagating through the compensating module, the relay module and the collection mirror before reaching the sample and a beam separation optics configured to separate the illumination beam from the light beam emitted by the sample.

13. The device according to any one of claims 1 to 12, wherein the collection mirror comprises a hole arranged such that a beam associated with the first measurement apparatus passes through the collection mirror to reach the sample.

14. A system comprising a device according to any one of claims 1 to 13, the system further comprising the first measurement apparatus and/or the optical microscope.

15. A method of use of a device according to any one of claims 1 to 13.
